# EUROPEAN PATENT APPLICATION

(11) **EP 4 586 641 A1**
(43) Date of publication of application: **16.07.2025**
(21) Application number: 22958201.0
(22) Date of filing: 02.12.2022
(51) Int. Cl.: H04R 3/00, A61M 21/02, G10K 15/02, G10K 15/04

(54) **PLAYBACK SYSTEM, PLAYBACK METHOD, AND PROGRAM**

(30) Priority: 05.09.2022 JP 2022141032
(71) Applicant: Panasonic Intellectual Property Management Co., Ltd., Kadoma-shi, Osaka 571-0057 (JP)
(72) Inventor: YAMAO, Takashi, Kadoma-shi, Osaka 571-0057 (JP); KAKUHARI, Isao, Kadoma-shi, Osaka 571-0057 (JP); OKUDA, Tadayoshi, Kadoma-shi, Osaka 571-0057 (JP)
(74) Representative: Novagraaf International SA
(86) International application number: PCT/JP2022/044501
(87) International publication number: WO 2024/053123

(57) **Abstract**

A reproduction system (1) for content induces a user's emotion from a first emotion to a second emotion, and includes: an obtainer (101) that obtains first content corresponding to the first emotion and second content corresponding to the second emotion; and a reproducer (103) that, using a loudspeaker (15), reproduces the first content together with first inaudible sound that corresponds to the first content and is created by amplifying a basic signal of the first inaudible sound by a first amplification factor, and thereafter reproduces the second content together with second inaudible sound that corresponds to the second content and is created by amplifying a basic signal of the second inaudible sound by a second amplification factor, wherein the reproducer (103): gradually decreases the first amplification factor of the first inaudible sound being reproduced, during reproduction of the first content; and gradually increases the second amplification factor of the second inaudible sound being reproduced, during reproduction of the second content.

## Description

### [Technical Field]

The present disclosure relates to a reproduction system, a reproduction method, and a program.

### [Background Art]

There is a technology that controls the reproduction of inaudible sound contained in audio sound depending on whether the driver needs to concentrate on driving the vehicle (see, for example, Patent Literature (PTL) 1).

### [Citation List]

### [Patent Literature]

[PTL 1]
Japanese Unexamined Patent Application Publication No. 2019-6191

### [Non Patent Literature]

[NPL 1]
   Junichiro Hayano, "Estimation of Emotion Spectra from Biosignals," [online], October 3, 2017, Health and Medical New Technology Presentation Meetings, Japan Science and Technology Agency, [searched August 29, 2022], Internet, <URL: https://shingi.jst.go.jp/list/list_2017/2017_3chubu.html#2017100 3X-008>
[NPL 2]
   Kaori Takeda, "Effect of Negative Emotions (Anger, Depression, Anxiety) on Blood Pressure," [online], March 31, 2011, Bulletin of Nayoro City University (2007.3+), Vol. 5, [searched August 29, 2022], Internet, <URL: http://id.nii.ac.jp/1088/00000025/>

### [Summary of Invention]

### [Technical Problem]

The present disclosure provides a reproduction system, reproduction method, and program that appropriately induce a user's emotion by using reproduction of inaudible sound.

### [Solution to Problem]

A reproduction system according to the present disclosure is a reproduction system for content, the reproduction system inducing a user's emotion from a first emotion to a second emotion, and including: an obtainer that obtains first content corresponding to the first emotion and second content corresponding to the second emotion; and a reproducer that, using a loudspeaker, (a) reproduces the first content together with first inaudible sound that corresponds to the first content and is created by amplifying a basic signal of the first inaudible sound by a first amplification factor, and thereafter (b) reproduces the second content together with second inaudible sound that corresponds to the second content and is created by amplifying a basic signal of the second inaudible sound by a second amplification factor, wherein the reproducer: gradually decreases the first amplification factor of the first inaudible sound being reproduced, during reproduction of the first content; and gradually increases the second amplification factor of the second inaudible sound being reproduced, during reproduction of the second content.

### [Advantageous Effects of Invention]

The reproduction system according to the present disclosure can appropriately induce a user's emotion by using reproduction of inaudible sound.

### [Brief Description of Drawings]

[FIG. 1]

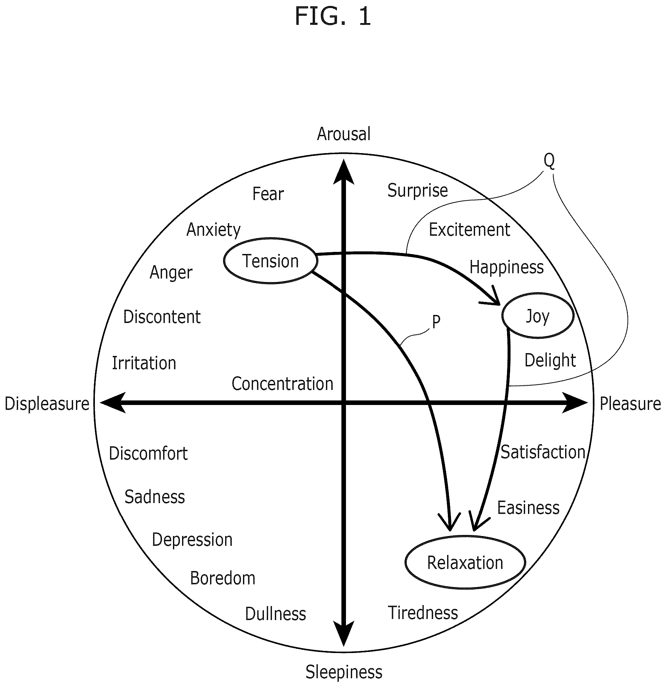

   FIG. 1 is an explanatory diagram illustrating human emotions and induction of emotions.
[FIG. 2]

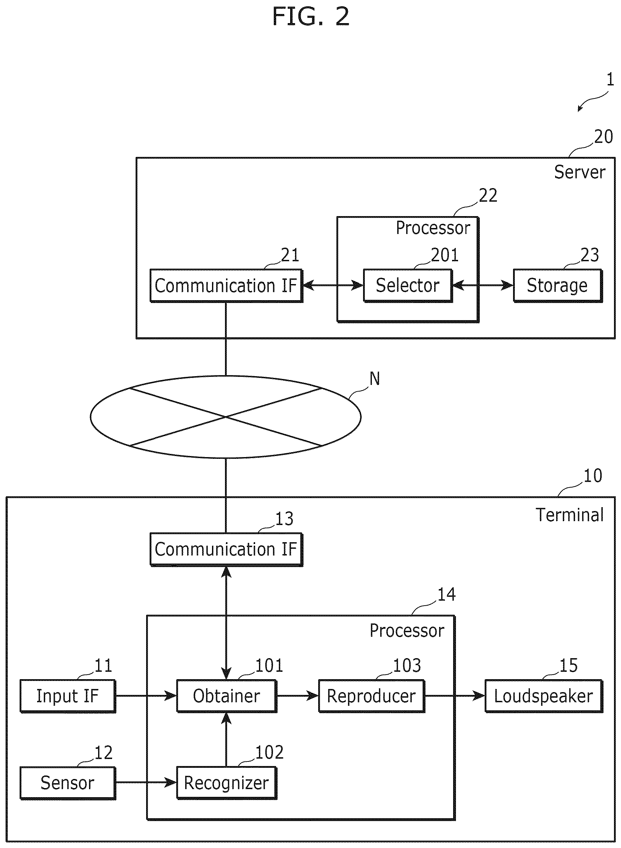

   FIG. 2 is a block diagram illustrating the structure of a reproduction system in an embodiment.
[FIG. 3]

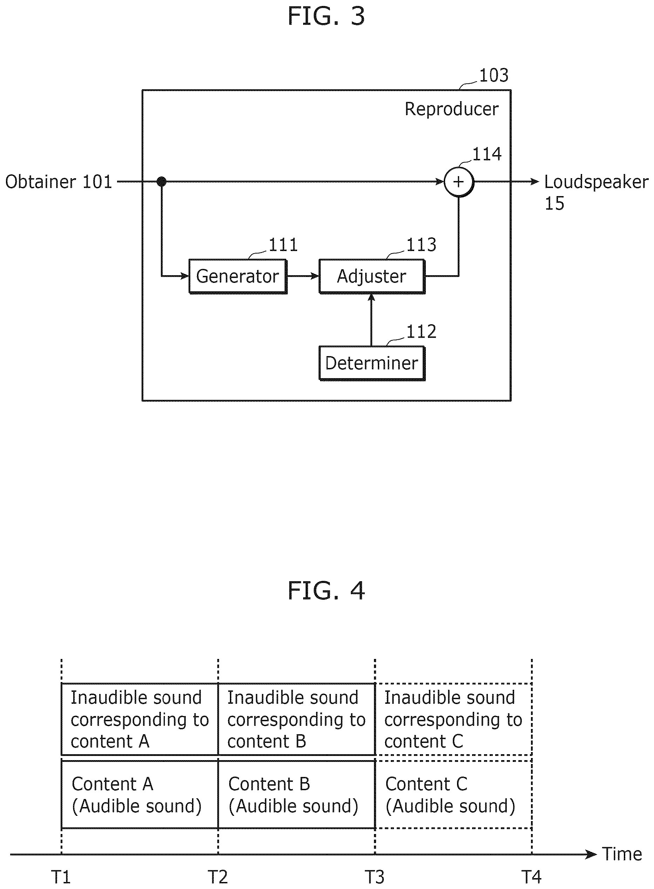

   FIG. 3 is a block diagram illustrating the structure of a reproducer in the embodiment.
[FIG. 4]
   FIG. 4 is an explanatory diagram illustrating the reproduction of content by the reproducer in the embodiment.
[FIG. 5]

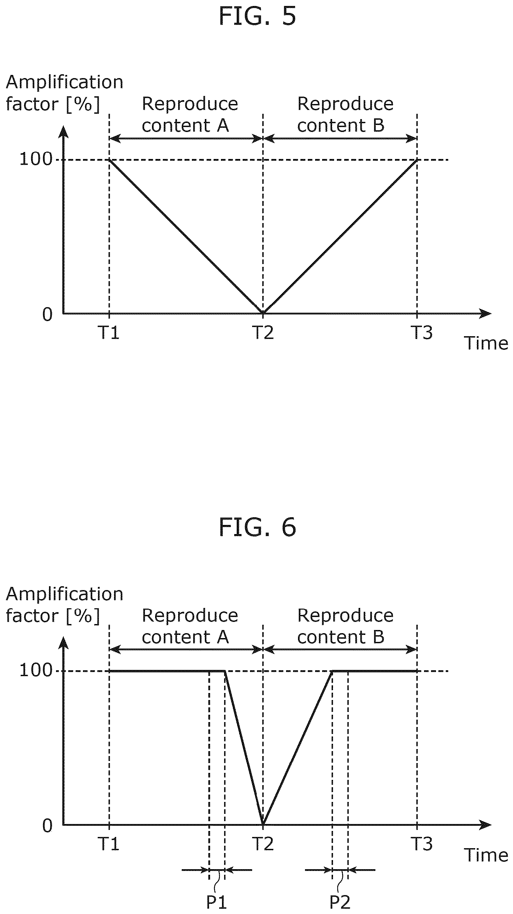

   FIG. 5 is an explanatory diagram illustrating a first example of an amplification factor transition in the embodiment.
[FIG. 6]
   FIG. 6 is an explanatory diagram illustrating a second example of an amplification factor transition in the embodiment.
[FIG. 7]

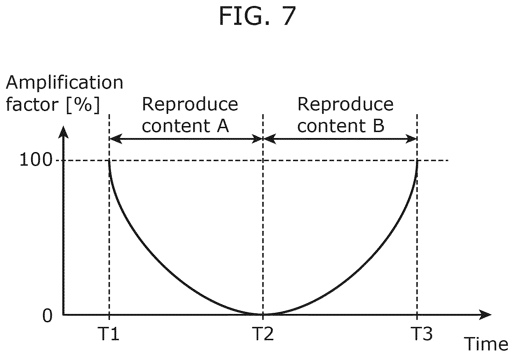

   FIG. 7 is an explanatory diagram illustrating a third example of an amplification factor transition in the embodiment.
[FIG. 8]

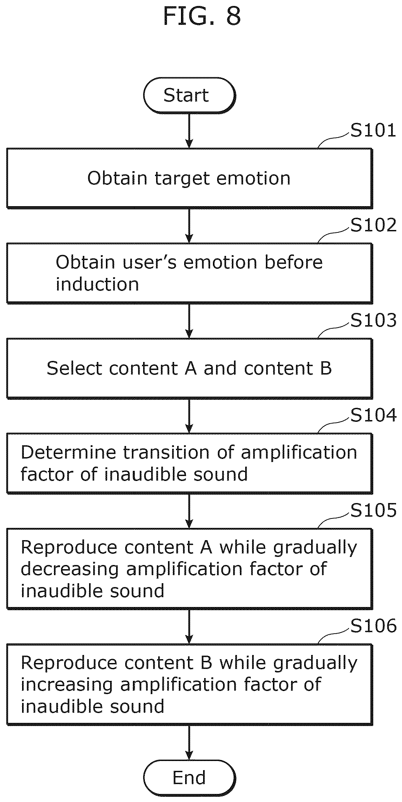

   FIG. 8 is a flowchart illustrating a first example of processing by the reproduction system in the embodiment.
[FIG. 9]

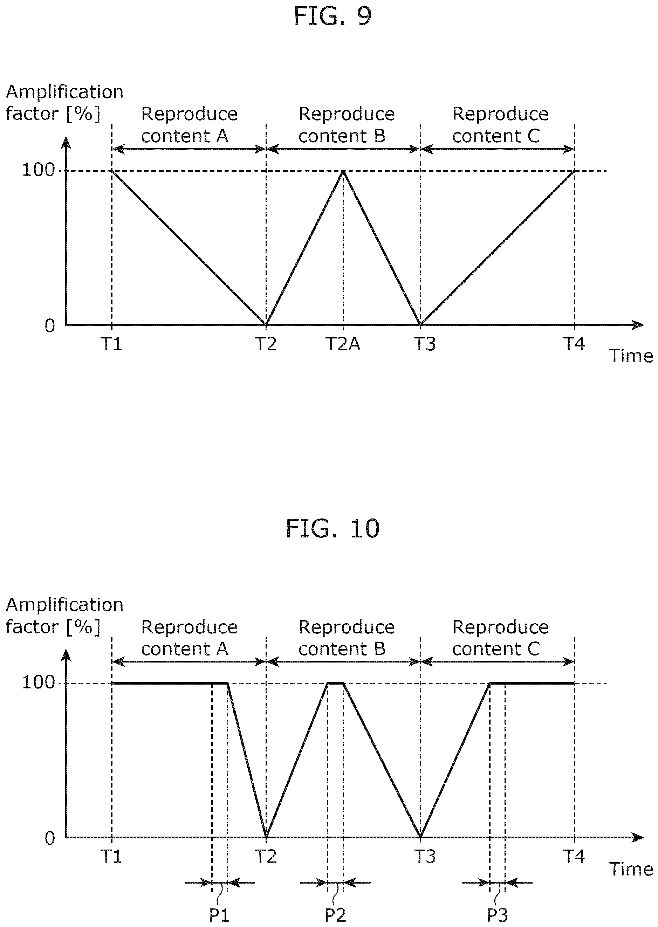

   FIG. 9 is an explanatory diagram illustrating a fourth example of an amplification factor transition in the embodiment.
[FIG. 10]
   FIG. 10 is an explanatory diagram illustrating a fifth example of an amplification factor transition in the embodiment.
[FIG. 11]

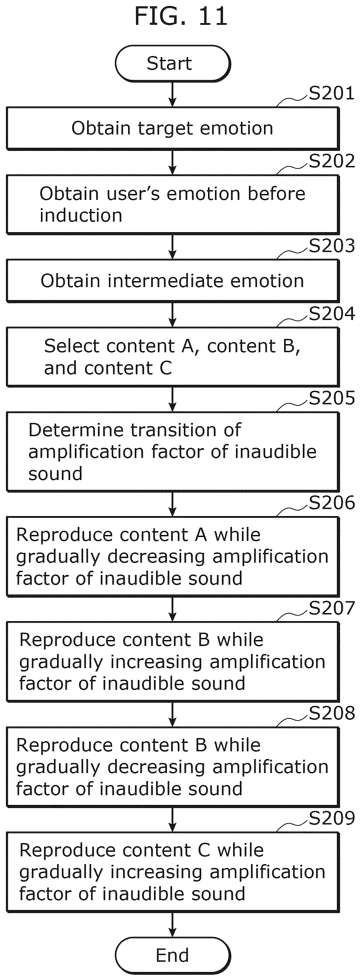

   FIG. 11 is a flowchart illustrating a second example of processing by the reproduction system in the embodiment.
[FIG. 12]

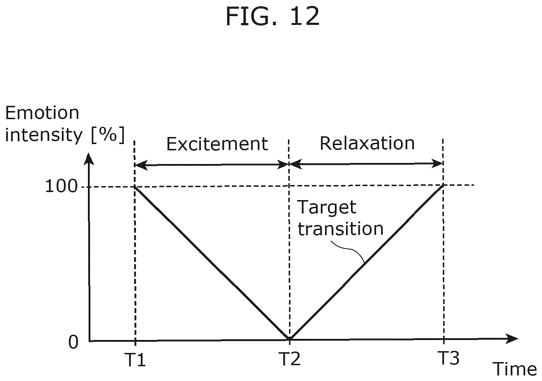

   FIG. 12 is an explanatory diagram illustrating a target transition in a variation of the embodiment.
[FIG. 13]

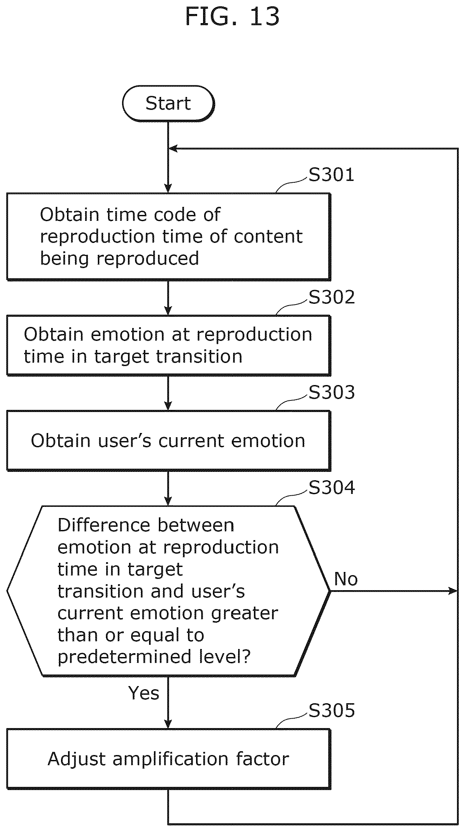

   FIG. 13 is a flowchart illustrating processing by a reproduction system in the variation of the embodiment.
[FIG. 14]

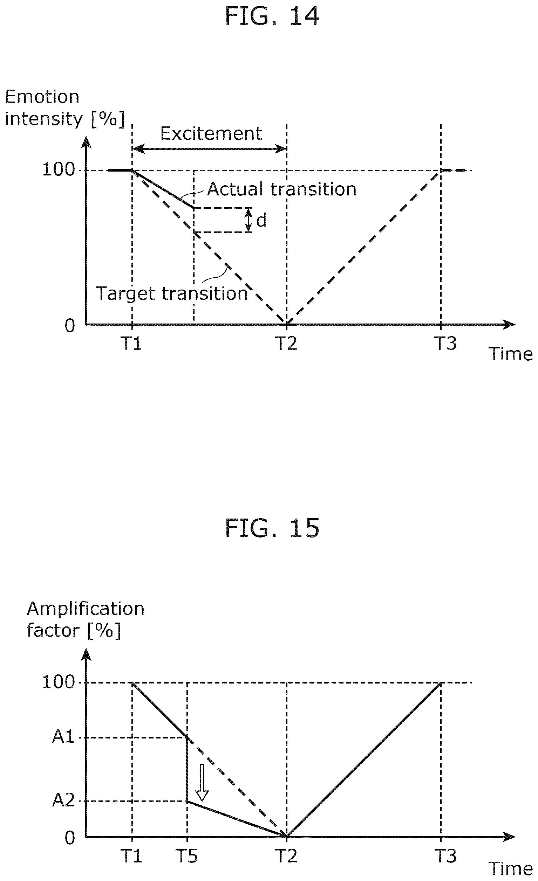

   FIG. 14 is an explanatory diagram illustrating an example of an emotion transition in the variation of the embodiment.
[FIG. 15]
   FIG. 15 is an explanatory diagram illustrating an example of an amplification factor transition in the variation of the embodiment.

### [Description of Embodiment]

### (Underlying Knowledge Forming Basis of the Present Disclosure)

The inventors of the present application have found the following problem with the technology related to reproduction of inaudible sound described in the "Background Art" section.

The foregoing technology is based on the premise that the audio sound of content contains audible sound and inaudible sound. The technology switches between applying and not applying a filter that removes the inaudible sound from the audio sound, thus switching between outputting the audible sound and the inaudible sound and outputting only the audible sound. It is known that inaudible sound has the effect of activating the brain of a person who perceives the inaudible sound.

Hence, when the driver needs to concentrate on driving the vehicle, the driver is made to perceive the audible sound and the inaudible sound, which contributes to the driver concentrating on driving. When the driver does not need to concentrate on driving, the driver is made to perceive only the audible sound, which contributes to the driver relaxing and enjoying the audio. The technology induces the driver's emotion in this way.

There is a principle called the "iso principle" regarding inducing human emotions. According to the iso principle, a person can, by listening to music that corresponds to (i.e. matches) the person's emotion, further strengthen the emotion. The "music that corresponds to an emotion" means music that gives the same impression as the emotion.

For example, when a person is relaxed, listening to music that corresponds to the emotion of relaxation can strengthen the emotion of relaxation. When a person is excited, listening to music that corresponds to the emotion of excitement can strengthen the emotion of excitement.

The inventors have conceived that, when inducing a person's emotion, making the person first listen to music that corresponds to the current emotion of the person (i.e. the emotion before the induction) and then listen to music that corresponds to the target emotion to be induced can induce the person's emotion more appropriately. The inventors have also conceived that, when inducing the emotion, reproducing inaudible sound and appropriately controlling the sound pressure of the inaudible sound being reproduced can control the intensity of the person's emotion and induce the person's emotion more appropriately.

The following will describe examples of inventions obtained from the disclosure of this specification, and the effects, etc. achieved by such inventions.

(1) A reproduction system for content, the reproduction system inducing a user's emotion from a first emotion to a second emotion, and including: an obtainer that obtains first content corresponding to the first emotion and second content corresponding to the second emotion; and a reproducer that, using a loudspeaker, (a) reproduces the first content together with first inaudible sound that corresponds to the first content and is created by amplifying a basic signal of the first inaudible sound by a first amplification factor, and thereafter (b) reproduces the second content together with second inaudible sound that corresponds to the second content and is created by amplifying a basic signal of the second inaudible sound by a second amplification factor, wherein the reproducer: gradually decreases the first amplification factor of the first inaudible sound being reproduced, during reproduction of the first content; and gradually increases the second amplification factor of the second inaudible sound being reproduced, during reproduction of the second content.
   According to this aspect, the reproduction system induces the user's emotion to the target emotion based on the iso principle by causing the user to perceive the first content, which gives the same impression as the user's emotion before induction (first emotion), together with inaudible sound and then causing the user to perceive the second content, which gives the same impression as the target emotion, together with inaudible sound. Here, the reproduction system gradually decreases the amplification factor of inaudible sound during the reproduction of the first content to weaken the intensity of the user's emotion before induction, and then gradually increases the amplification factor of inaudible sound during the reproduction of the second content to strengthen the intensity of the user's target emotion. Thus, the reproduction system can appropriately induce the user's emotion by using reproduction of inaudible sound.
(2) The reproduction system according to (1), wherein the reproducer sets the first amplification factor to 0 at end of the reproduction of the first content, and sets the second amplification factor to 0 at start of the reproduction of the second content.
   According to this aspect, the reproduction system sets the amplification factor of inaudible sound to 0 at the timing of switching the content to be reproduced, so that the content can be switched at the timing when the intensity of the user's emotion before induction is weakest. Subsequently, the reproduction system gradually strengthens the target emotion. Thus, the reproduction system can more appropriately induce the user's emotion by using reproduction of inaudible sound.
(3) The reproduction system according to (1) or (2), wherein the reproducer: during the reproduction of the first content, maintains the first amplification factor of the first inaudible sound being reproduced at a first value in a first section from start of the first content to end of a climax part included in the first content, and gradually decreases the first amplification factor of the first inaudible sound being reproduced from the first value in a section after the first section; and during the reproduction of the second content, maintains the second amplification factor of the second inaudible sound being reproduced at a second value in a second section from start of a climax part included in the second content to end of the second content, and gradually increases the second amplification factor of the second inaudible sound being reproduced to the second value in a section before the second section.
   According to this aspect, the reproduction system can further enhance the intensity of the user's emotion before induction when the user is perceiving the climax part of the first content, and further enhance the intensity of the user's target emotion when the user is perceiving the climax part of the second content. Thus, the reproduction system can more appropriately induce the user's emotion.
(4) The reproduction system according to any of (1) to (3), wherein the reproducer gradually decreases the first amplification factor during the reproduction of the first content by linearly decreasing the first amplification factor with respect to time, and gradually increases the second amplification factor during the reproduction of the second content by linearly increasing the second amplification factor with respect to time.
   According to this aspect, the reproduction system can decrease or increase the amplification factor of inaudible sound by a relatively simple process of linearly decreasing or increasing the amplification factor of inaudible sound with respect to time. Thus, the reproduction system can appropriately induce the user's emotion by using reproduction of inaudible sound through a relatively simple process.
(5) The reproduction system according to any of (1) to (3), wherein the reproducer gradually decreases the first amplification factor during the reproduction of the first content by exponentially decreasing the first amplification factor with respect to time, and gradually increases the second amplification factor during the reproduction of the second content by exponentially increasing the second amplification factor with respect to time.
   According to this aspect, the reproduction system exponentially decreases or increases the amplification factor of inaudible sound with respect to time, so that the user can feel the degree of intensity of inaudible sound close to the degree of intensity of sound as perceived by humans, that is, the user can feel inaudible sound with the degree of intensity natural to humans. Thus, the reproduction system can appropriately induce the user's emotion by using reproduction of inaudible sound with an appropriate degree of intensity.
(6) The reproduction system according to any of (1) to (5), further including: a recognizer that recognizes the user's emotion when the reproducer is reproducing the first content or the second content, wherein when the user's emotion recognized by the recognizer deviates from a predetermined transition, the reproducer adjusts the first amplification factor of the first inaudible sound being reproduced to bring the user's emotion closer to the predetermined transition.
   According to this aspect, when the user's emotion during reproduction of content is transitioning differently from the predetermined transition, the reproduction system can make the transition of the user's emotion closer to the predetermined transition. Thus, the reproduction system can more appropriately induce the user's emotion by using reproduction of inaudible sound.
(7) The reproduction system according to any of (1) to (5), further including: a recognizer that recognizes the user's emotion when the reproducer is reproducing the first content or the second content, wherein when the user's emotion recognized by the recognizer deviates from a predetermined transition, the reproducer sets the amplification factor of the first inaudible sound being reproduced to 0.
   According to this aspect, when the user's emotion during reproduction of content is transitioning differently from the predetermined transition, the reproduction system stops reproduction of inaudible sound to thereby prevent adversely affecting the user. Thus, the reproduction system can more appropriately induce the user's emotion by using reproduction of inaudible sound.
(8) The reproduction system according to any of (1) to (7), wherein the reproducer starts the reproduction of the second content when the reproduction of the first content ends.
   According to this aspect, the reproduction system easily induces the user's emotion by successively reproducing the first content and the second content. Thus, the reproduction system can appropriately induce the user's emotion more easily by using reproduction of inaudible sound.
(9) The reproduction system according to any of (1) to (8), inducing the user's emotion from the first emotion to the second emotion via one or more third emotions, wherein the obtainer obtains one or more items of third content each corresponding to a different one of the one or more third emotions, and the reproducer: sequentially reproduces the one or more items of third content each together with third inaudible sound that corresponds to the item of third content, after the reproduction of the first content ends; starts the reproduction of the second content when reproduction of the one or more items of third content ends; and during reproduction of each of the one or more items of third content, gradually increases and thereafter gradually decreases a third amplification factor of the third inaudible sound being reproduced.
   According to this aspect, the reproduction system easily induces the user's emotion by successively reproducing the first content, the third content, and the second content in this order. Thus, the reproduction system can appropriately induce the user's emotion more easily by using reproduction of inaudible sound.
(10) The reproduction system according to (9), wherein the reproducer sets the third amplification factor to 0 at start and end of the reproduction of the one or more items of third content.
   According to this aspect, the reproduction system sets the amplification factor of inaudible sound to 0 at the timing of switching the content to be reproduced, so that the content can be switched at the timing when the intensity of the user's emotion before induction is weakest. Subsequently, the reproduction system gradually strengthens the target emotion. Thus, the reproduction system can more appropriately induce the user's emotion by using reproduction of inaudible sound.
(11) The reproduction system according to (9) or (10), wherein during the reproduction of each of the one or more items of third content, the reproducer maintains the third amplification factor of the third inaudible sound being reproduced at a third value in a third section that includes start to end of a climax part of the item of third content, gradually increases the third amplification factor of the third inaudible sound being reproduced to the third value in a section before the third section, and gradually decreases the third amplification factor of the third inaudible sound being reproduced from the third value in a section after the third section.
   According to this aspect, the reproduction system can further enhance the intensity of the user's intermediate emotion when the user is perceiving the climax part of the third content. Thus, the reproduction system can more appropriately induce the user's emotion via the intermediate emotion.
(12) The reproduction system according to any of (1) to (11), further including: a selector that selects the first content corresponding to the first emotion and the second content corresponding to the second emotion from among a plurality of items of content, wherein the obtainer obtains the first content and the second content selected by the selector.
   According to this aspect, the reproduction system can appropriately select the first content and the second content respectively corresponding to the user's emotion before induction and the target emotion, and induce the user's emotion using the selected first content and second content. Thus, the reproduction system can appropriately induce the user's emotion by using appropriate content and reproduction of inaudible sound corresponding to the content.
(13) A reproduction method executed by one or more computers included in a reproduction system for content, the reproduction system inducing a user's emotion from a first emotion to a second emotion, the reproduction method including: obtaining first content corresponding to the first emotion and second content corresponding to the second emotion; with use of a loudspeaker, (a) reproducing the first content together with first inaudible sound that corresponds to the first content and is created by amplifying a basic signal of the first inaudible sound by a first amplification factor, and thereafter (b) reproducing the second content together with second inaudible sound that corresponds to the second content and is created by amplifying a basic signal of the second inaudible sound by a second amplification factor; gradually decreasing the first amplification factor of the first inaudible sound being reproduced, during reproduction of the first content; and gradually increasing the second amplification factor of the second inaudible sound being reproduced, during reproduction of the second content.
   According to this aspect, the same effects as the foregoing reproduction system can be achieved.
(14) A program for causing a computer to execute the reproduction method according to (13).

According to this aspect, the same effects as the foregoing reproduction system can be achieved.

An embodiment will be described in detail below, by referring to drawings as appropriate. Herein, description detailed more than necessary may be omitted. For example, detailed description of well-known matters or repeated description of the substantially same structures may be omitted. This is to avoid unnecessarily redundant description and facilitate the understanding of a person skilled in the art.

The accompanying drawings and the following description are provided to help a person skilled in the art to fully understand the present disclosure, and are not intended to limit the subject matter defined in the appended claims.

### [Embodiment]

In this embodiment, a reproduction system that appropriately induces a user's emotion by using reproduction of inaudible sound will be described.

First, human emotions will be described with reference to FIG. 1.

FIG. 1 is an explanatory diagram illustrating human emotions and changes (also referred to as transitions) in human emotions.

FIG. 1 is a diagram in which a plurality of human emotions (for example, tension, joy, and relaxation) are arranged in a circular ring. This is also commonly called Russell's circumplex model of emotion.

As illustrated in FIG. 1, it is known that human emotions are arranged on a two-dimensional plane composed of an axis of pleasure and displeasure (horizontal axis) and an axis of arousal and sleepiness (vertical axis). Emotions may include concepts such as feelings, moods, psychological states, and affects.

A person's emotional transition is expressed as movement from a position corresponding to one emotion to a position corresponding to another emotion in FIG. 1. Transitioning a person's emotion is also referred to as inducing a person's emotion.

For example, when inducing a person's emotion from tension to relaxation, one of a plurality of routes can be taken. Routes from tension to relaxation are, for example, routes P and Q. Route P is a route that transitions from tension to relaxation directly (i.e. without passing through any other emotion). Route Q is a route that transitions from tension to relaxation via the emotion of joy, which is an example of another emotion. When the distance between the person's emotion before induction and the person's emotion after induction is relatively large, it may be appropriate to induce the emotion via another emotion.

Reproduction system 1 according to this embodiment contributes to appropriately inducing a user's emotion to a targeted emotion through any route.

### [1. Structure]

FIG. 2 is a block diagram illustrating the structure of reproduction system 1 in this embodiment.

Reproduction system 1 is an information processing system that induces a user's emotion from an emotion prior to induction (also referred to as an emotion before induction or a first emotion) to a targeted emotion (also referred to as a target emotion or a second emotion).

As illustrated in FIG. 2, reproduction system 1 includes terminal 10 and server 20. Terminal 10 and server 20 are connected via network N. Network N may be any communication line or network. Examples of network N include the Internet, a mobile phone carrier network, an Internet provider access network, and a public access network.

Terminal 10 is an information processing terminal that outputs sound related to content to cause the user to perceive the sound. Examples of terminal 10 include a smartphone, a tablet, and a personal computer.

As illustrated in FIG. 2, terminal 10 includes input IF 11, sensor 12, communication IF 13, processor 14, and loudspeaker 15.

Input IF 11 receives information input from the user. The information received by input IF 11 includes a target emotion (for example, relaxation). The information received by input IF 11 may also include an emotion (also referred to as an intermediate emotion) via which the user's emotion is to be induced from the emotion before induction to the target emotion. When reproduction system 1 induces the user's emotion from the emotion before induction to the target emotion via the intermediate emotion, the information received by input IF 11 needs to include the intermediate emotion (for example, joy). The number of intermediate emotions may be one or more.

Input IF 11 is, for example, a touch interface, a keyboard, a mouse, a microphone, etc. When input IF 11 includes a touch interface, a keyboard, or a mouse, input IF 11 receives the information through key operation, clicking, tapping, etc. When input IF 11 includes a microphone, input IF 11 receives the information using voice recognition processing for the user's voice received by the microphone.

Sensor 12 senses physical quantities related to the user's body, and generates biological information (also referred to as biometric information). Sensor 12 provides the generated biometric information to processor 14 (more specifically, recognizer 102).

Sensor 12 is, for example, a camera, a body temperature sensor, a heart rate sensor, a blood pressure sensor, etc. The camera captures an image of the user's face (also referred to as a facial image) by photographing the user's face, and provides the image to processor 14 as biometric information.

Sensor 12 may be included in a device external to terminal 10. In this case, the device and terminal 10 are connected so as to be able to communicate with each other, and sensor 12 transmits the biometric information to terminal 10 through communication. The device may be, for example, a wristband-type device worn on the user's wrist.

Communication IF 13 is a communication interface capable of communicating with server 20 via network N. Communication IF 13 may be a wireless local area network (LAN) interface such as Wi-Fi^{®}, or a wired LAN interface such as Ethernet^{®}.

Processor 14 executes a predetermined program using memory (not illustrated) to implement the software functions of terminal 10. The software functions implemented by processor 14 will be described later.

Loudspeaker 15 outputs sound. The sound output by loudspeaker 15 includes not only audible sound but also inaudible sound. Audible sound is sound in a frequency band perceivable by humans, and is typically in the range of 20 Hz to 20 kHz. Inaudible sound is sound in a frequency band not perceivable by humans, and is outside the frequency range of audible sound. Herein, sound (high-frequency inaudible sound) whose frequency is higher than the frequency range of audible sound is referred to as inaudible sound.

Loudspeaker 15 outputs sound based on waveform data of the amplitude of sound pressure (also simply referred to as waveform data) provided by processor 14 (more specifically, reproducer 103).

Terminal 10 may include an output IF instead of loudspeaker 15. In this case, the output IF is connected to an external loudspeaker, and outputs waveform data to the external loudspeaker to output sound.

The following will describe obtainer 101, recognizer 102, and reproducer 103, which are functional units implemented by processor 14 executing a predetermined program using memory (not illustrated).

Recognizer 102 recognizes the user's emotion. Recognizer 102 recognizes the user's emotion using the biometric information of the user provided by sensor 12. Recognizer 102 recognizes the user's emotion before induction (i.e. before reproduction of content). Recognizer 102 may also recognize the user's emotion during induction (i.e. during reproduction of content).

For example, recognizer 102 recognizes the user's emotion by analyzing the user's facial expression from the facial image of the user captured by the camera included in sensor 12. Well-known emotion recognition technology may be used to recognize the user's emotion.

For example, recognizer 102 recognizes the user's emotion from the body temperature measured by the body temperature sensor included in sensor 12. Here, recognizer 102 can recognize the user's emotion from the measured body temperature using a known correspondence relationship between human emotion and body temperature. As an example of the known correspondence relationship between human emotion and body temperature, a relatively high body temperature is associated with emotions such as happiness and anger, and a relatively low body temperature is associated with emotions such as sadness and depression.

For example, recognizer 102 recognizes the user's emotion from the heart rate variability measured by the heart rate sensor included in sensor 12. Here, recognizer 102 can recognize the user's emotion from the measured heart rate variability using a known correspondence relationship between human emotion and heart rate variability. A known correspondence relationship between human emotion and heart rate variability is described, for example, in Non Patent Literature (NPL) 1. For example, it is known that a person who is feeling any of the emotions such as joy, anxiety, surprise, sadness, and anger shows characteristic heart rate variability corresponding to the emotion.

For example, recognizer 102 recognizes the user's emotion from the blood pressure measured by the blood pressure sensor included in sensor 12. Here, recognizer 102 can recognize the user's emotion from the measured blood pressure using a known correspondence relationship between human emotion and blood pressure. A known correspondence relationship between human emotion and blood pressure is described, for example, in NPL 2. For example, an increase in blood pressure corresponds to the emotion of anger, and a decrease in blood pressure corresponds to the emotion of relaxation.

Obtainer 101 obtains content to be used for inducing the user's emotion. The content obtained by obtainer 101 is content that includes at least sound, for example, music content. This case will be described as an example. The content obtained by obtainer 101 may be content that includes video in addition to sound.

Specifically, obtainer 101 obtains first content corresponding to the emotion before induction and second content corresponding to the target emotion from server 20 via communication IFs 13 and 21 and network N. Obtainer 101 converts each of the obtained first content and second content into waveform data (also referred to as waveform data of a sound source), and provides the waveform data to reproducer 103.

In order to obtain the first content and the second content from server 20, obtainer 101 provides the user's emotion before induction and the target emotion to server 20 via communication IFs 13 and 21 and network N. The first content and the second content obtained by obtainer 101 are items of content selected by server 20 (more specifically, selector 201 described later) as corresponding to the emotion before induction and the target emotion respectively. The emotion before induction is the user's emotion obtained by sensor 12 and recognizer 102 before reproducer 103 reproduces the first content. The target emotion is the target emotion input to input IF 11.

When reproduction system 1 induces the user's emotion directly from the emotion before induction to the target emotion, obtainer 101 obtains the first content and the second content as described above. When reproduction system 1 induces the user's emotion from the emotion before induction to the target emotion via an intermediate emotion, obtainer 101 obtains third content corresponding to the intermediate emotion in addition to the first content and the second content. In order to obtain the third content from server 20, obtainer 101 may provide the intermediate emotion to server 20. The intermediate emotion may be generated by terminal 10 using the emotion before induction and the target emotion, for example.

Reproducer 103 sequentially reproduces the first content and the second content provided by obtainer 101, through loudspeaker 15. Reproducer 103 first reproduces the first content together with inaudible sound corresponding to the first content (also referred to as first inaudible sound), and then reproduces the second content together with inaudible sound corresponding to the second content (also referred to as second inaudible sound). The first inaudible sound is inaudible sound created by amplifying a basic signal of the first inaudible sound, and the second inaudible sound is inaudible sound created by amplifying a basic signal of the second inaudible sound. The amplification factor of the first inaudible sound is also referred to as a first amplification factor, and the amplification factor of the second inaudible sound is also referred to as a second amplification factor. Reproducer 103 gradually decreases the first amplification factor of the first inaudible sound being reproduced during the reproduction of the first content, and gradually increases the second amplification factor of the second inaudible sound being reproduced during the reproduction of the second content. The basic signal will be described in detail later.

Reproducer 103 may provide a period during which the first amplification factor of the first inaudible sound being reproduced is maintained, during the reproduction of the first content. Reproducer 103 may provide a period during which the second amplification factor of the second inaudible sound being reproduced is maintained, during the reproduction of the second content.

Reproducer 103 may set the first amplification factor of the first inaudible sound being reproduced at the end of the reproduction of the first content and the second amplification factor of the second inaudible sound being reproduced at the start of the reproduction of the second content to the same value. The same value is, for example, 0. Reproducer 103 may maintain the first amplification factor of the first inaudible sound being reproduced at the same value for a certain period including the end of the reproduction of the first content. Reproducer 103 may maintain the second amplification factor of the second inaudible sound being reproduced at the same value for a certain period including the start of the reproduction of the second content.

Reproducer 103 updates, by addition, a code (also referred to as a time code) indicating the reproduction position of the content being reproduced, and reproduces the content with reference to the time code. The structure of reproducer 103 will be described in detail later.

As illustrated in FIG. 2, server 20 includes communication IF 21, processor 22, and storage 23.

Communication IF 21 is a communication interface capable of communicating with terminal 10 via network N. Communication IF 21 may be a wireless LAN interface such as Wi-Fi, or a wired LAN interface such as Ethernet.

Processor 22 executes a predetermined program using memory (not illustrated) to implement the software functions of server 20. The software functions implemented by processor 22 will be described later.

Storage 23 stores a plurality of items of content. The plurality of items of content stored in storage 23 are a plurality of items of content that may potentially be reproduced on terminal 10. The plurality of items of content stored in storage 23 are read by processor 22 (more specifically, selector 201). Storage 23 may be implemented by memory, a hard disk drive (HDD), etc.

Selector 201 implemented by processor 22 executing a predetermined program using memory (not illustrated) will be described.

Selector 201 selects content. Specifically, selector 201 provides the first content corresponding to the emotion before induction and the second content corresponding to the target emotion to terminal 10 via communication IFs 13 and 21 and network N.

Specifically, selector 201 obtains the user's emotion before induction from obtainer 101 via communication IFs 21 and 13 and network N, and selects content corresponding to the obtained emotion before induction as the first content. Selector 201 holds in advance a correspondence relationship in which each of the plurality of items of content stored in storage 23 is associated with an emotion, and selects the first content corresponding to the emotion before induction with reference to the correspondence relationship.

Selector 201 also obtains the target emotion from obtainer 101 via communication IFs 21 and 13 and network N, and selects content corresponding to the obtained target emotion as the second content. Selector 201 selects the second content corresponding to the target emotion with reference to the correspondence relationship.

When reproduction system 1 induces the user's emotion from the emotion before induction to the target emotion via an intermediate emotion, selector 201 selects content corresponding to the intermediate emotion as the third content. Selector 201 selects the third content corresponding to the intermediate emotion with reference to the correspondence relationship. Selector 201 may obtain the intermediate emotion from terminal 10, or generate the intermediate emotion using the emotion before induction and the target emotion.

FIG. 3 is a block diagram illustrating the structure of reproducer 103 in this embodiment.

As illustrated in FIG. 3, reproducer 103 includes generator 111, determiner 112, adjuster 113, and adder 114.

Generator 111 generates a basic signal of inaudible sound corresponding to content. Generator 111 generates waveform data of the basic signal of inaudible sound based on the waveform data of the sound source provided by obtainer 101. More specifically, generator 111 generates a basic signal of inaudible sound corresponding to the first content and a basic signal of inaudible sound corresponding to the second content based on the waveform data of the first content and the waveform data of the second content, respectively. When the third content is used, generator 111 also generates a basic signal of inaudible sound (third inaudible sound) corresponding to the third content based on the waveform data of the third content. Generator 111 provides the generated waveform data of the basic signal of inaudible sound to adjuster 113.

Generating waveform data of a basic signal of inaudible sound based on waveform data of audible sound can be achieved, for example, by removing the audible sound component from the waveform data including the inaudible sound, which is generated by performing clip processing on the waveform data obtained by amplifying the waveform data of the sound source (i.e. the waveform data of the audible sound).

Determiner 112 determines the amplification factor of the basic signal of inaudible sound (also simply referred to as the amplification factor of inaudible sound) generated by generator 111. Specifically, determiner 112 determines the amplification factor of inaudible sound based on the time code updated by reproducer 103. The amplification factors determined by determiner 112 include the first amplification factor and the second amplification factor, and also include the third amplification factor which is the amplification factor of the third inaudible sound when the third content is used. For example, determiner 112 holds the transition in the amplification factor of inaudible sound determined for the time code, and determines the amplification factor of the inaudible sound to be added to the waveform data provided from obtainer 101 to generator 111 for each time with reference to the transition in the amplification factor. The transition in the amplification factor of the inaudible sound will be described later.

Adjuster 113 multiplies the amplitude of the waveform data of the inaudible sound generated by generator 111 by the amplification factor determined by determiner 112, to adjust the sound pressure of the inaudible sound to be reproduced. Adjuster 113 provides the adjusted waveform data of the inaudible sound to adder 114.

Adder 114 adds the waveform data of the inaudible sound provided by adjuster 113 to the waveform data of the sound source provided by obtainer 101, to generate waveform data to be reproduced by loudspeaker 15.

Reproduction of content by reproducer 103 will be described below.

FIG. 4 is an explanatory diagram illustrating reproduction of content by reproducer 103 in this embodiment.

When reproduction system 1 induces the user from the emotion before induction directly to the target emotion, reproducer 103 reproduces two items of content. The two items of content correspond to content A and content B in FIG. 4.

Specifically, reproducer 103 starts reproducing content A at time T1. When reproducing content A, reproducer 103 reproduces inaudible sound generated according to content A. Reproducer 103 reproduces content A to the end. The time when reproducer 103 finishes reproducing content A is time T2.

Next, reproducer 103 starts reproducing content B at time T2. When reproducing content B, reproducer 103 reproduces inaudible sound generated according to content B. Reproducer 103 reproduces content B to the end. The time when reproducer 103 finishes reproducing content B is time T3.

As mentioned above, time T2 depends on the reproduction duration of content A, and time T3 depends on the reproduction duration of content A and content B. Hence, the duration from time T1 to time T2 and the duration from time T2 to time T3 are independent of each other. In other words, the duration from time T1 to time T2 and the duration from time T2 to time T3 may be the same or different.

When reproducer 103 finishes reproducing content B, the reproduction of the series of content ends. In this case, content A corresponds to the first content, and content B corresponds to the second content.

When reproduction system 1 induces the user from the emotion before induction to the target emotion via one intermediate emotion, reproducer 103 reproduces three items of content. The three items of content correspond to content A, content B, and content C in FIG. 4.

Specifically, reproducer 103 reproduces content A and content B as in the foregoing case of reproducing two items of content, and then reproduces content C. When reproducing content C, reproducer 103 starts reproducing content C at time T3. When reproducing content C, reproducer 103 reproduces inaudible sound generated according to content C. Reproducer 103 reproduces content C to the end. The time when reproducer 103 finishes reproducing content C is time T4.

As mentioned above, time T4 depends on the reproduction duration of content A, content B, and content C. Hence, the duration from time T3 to time T4 is independent of the duration from time T1 to time T2 or the duration from time T2 to time T3. In other words, the duration from time T3 to time T4 may be the same as or different from the duration from time T1 to time T2 or the duration from time T2 to time T3.

When reproducer 103 finishes reproducing content C, the reproduction of the series of content ends. In this case, content A corresponds to the first content, content C corresponds to the second content, and content B corresponds to the third content.

When reproduction system 1 induces the user from the emotion before induction to the target emotion via a plurality of intermediate emotions, the number of items of content B is more than one in the foregoing case of reproducing three items of content.

The following will describe the transition of the amplification factor of inaudible sound for each of the case where reproduction system 1 induces the user's emotion using two items of content and the case where reproduction system 1 induces the user's emotion using three items of content.

### [2. Transition of amplification factor of inaudible sound (when two items of content are used)]

A plurality of examples of the transition of the amplification factor of inaudible sound (first inaudible sound and second inaudible sound) when reproduction system 1 induces the user's emotion by reproducing two items of content will be described below. Reproducer 103 (more specifically, determiner 112) determines the transition of the amplification factor and determines the amplification factor of inaudible sound for each time.

FIG. 5 is an explanatory diagram illustrating a first example of the transition of the amplification factor in this embodiment.

In the transition of the amplification factor illustrated in FIG. 5, reproducer 103 linearly decreases the amplification factor from 100% to 0% with respect to time during the period from time T1 to time T2, and linearly increases the amplification factor from 0% to 100% with respect to time during the period from time T2 to time T3. Reproducer 103 can generate such transition of the amplification factor that linearly decreases or increases with respect to time by a relatively simple process.

In this way, reproduction system 1 can induce the user's emotion while adjusting the amplification factor of inaudible sound by a relatively simple process.

FIG. 6 is an explanatory diagram illustrating a second example of the transition of the amplification factor in this embodiment.

The transition of the amplification factor illustrated in FIG. 6 is set based on the position of the climax part of content. Herein, the "climax part" is a relatively exciting part of the content, that is, a part that gives a relatively strong impression to the user who perceives the part. The climax part of the content can be detected, for example, by a process of extracting part of the content where the sound pressure is relatively high, which can be executed by reproducer 103.

In FIG. 6, climax part P1 is the climax part of content A, and climax part P2 is the climax part of content B.

In the transition of the amplification factor illustrated in FIG. 6, reproducer 103 maintains the amplification factor at 100% during the period from time T1 to the end of climax part P1, and linearly decreases the amplification factor from 100% to 0% with respect to time during the period from the end of climax part P1 to time T2.

Reproducer 103 linearly increases the amplification factor from 0% to 100% with respect to time during the period from time T2 to the start of climax part P2, and maintains the amplification factor at 100% during the period from the start of climax part P2 to time T3. The section from the start of content A to the end of climax part P1 is also referred to as a first section, and the section from the start of climax part P2 to the end of content B is also referred to as a second section. The amplification factor in the first section is also referred to as a first value. The first value may be selected from a relatively high amplification factor range (for example, 70% to 100%). The amplification factor in the second section is also referred to as a second value. The second value may be selected from a relatively high amplification factor range (for example, 70% to 100%).

Reproducer 103 can generate such transition of the amplification factor that linearly decreases or increases with respect to time by a relatively simple process.

If content A has a plurality of climax parts, any of the plurality of climax parts may be set as climax part P1. If content B has a plurality of climax parts, any of the plurality of climax parts may be set as climax part P2.

If content A has a plurality of climax parts, the last of the plurality of climax parts may be set as climax part P1. If content B has a plurality of climax parts, the first of the plurality of climax parts may be set as climax part P2.

In this way, reproduction system 1 can more appropriately induce the user's emotion while enhancing the intensity of the user's emotion when reproducer 103 is reproducing the climax part of each content, by adjusting the amplification factor of inaudible sound by a relatively simple process.

FIG. 7 is an explanatory diagram illustrating a third example of the transition of the amplification factor in this embodiment.

The transition of the amplification factor illustrated in FIG. 7 is a nonlinear transition with respect to time.

In the transition of the amplification factor illustrated in FIG. 7, reproducer 103 exponentially decreases the amplification factor from 100% to 0% with respect to time during the period from time T1 to time T2. Reproducer 103 also exponentially increases the amplification factor from 0% to 100% with respect to time during the period from time T2 to time T3.

The transition of the amplification factor illustrated in FIG. 7 is commonly called the A curve. The transition of the amplification factor illustrated in FIG. 5 is commonly called the B curve. It is normally considered that the degree of intensity of sound whose amplification factor is adjusted according to the A curve is relatively close to human perception of the degree of sound intensity. Therefore, the use of the amplification factor that transitions according to the A curve can naturally induce the intensity of the user's emotion.

In this way, reproduction system 1 can induce the intensity of the user's emotion more naturally.

The transition of the amplification factor illustrated in FIG. 7 is generated by replacing the linear changes in the transition of the amplification factor illustrated in FIG. 5 with exponential changes. Likewise, the linear changes in the transition of the amplification factor illustrated in FIG. 6 may be replaced with exponential changes. Thus, reproduction system 1 can more appropriately induce the user's emotion while enhancing the intensity of the user's emotion when reproducer 103 is reproducing the climax part of each content.

### [3. Processing by reproduction system 1 (when two items of content are used)]

FIG. 8 is a flowchart illustrating a first example of processing by reproduction system 1 in this embodiment. The structural elements that execute the below-described processing (terminal 10, server 20, and the structural elements included in terminal 10 and server 20) are merely examples, and other structural elements may execute the processing.

In Step S101, obtainer 101 obtains a target emotion using input IF 11.

In Step S102, obtainer 101 obtains the user's emotion before induction using sensor 12 and recognizer 102.

In Step S103, obtainer 101 transmits the user's emotion before induction and the target emotion to server 20, and requests content to be reproduced by terminal 10. Selector 201 obtains the user's emotion before induction and the target emotion transmitted by obtainer 101, selects content corresponding to the obtained user's emotion before induction and target emotion, that is, content to be reproduced by terminal 10, and provides the selected content to obtainer 101. The content to be reproduced by terminal 10 includes content A and content B. Content A is content associated with the user's emotion before induction, and content B is content associated with the target emotion. Obtainer 101 obtains the content provided by selector 201.

In Step S104, reproducer 103 determines the transition of the amplification factor of inaudible sound. The determined transition of the amplification factor is, for example, the transition of the amplification factor illustrated in FIG. 5, 6, or 7.

In Step S105, reproducer 103 reproduces content A while gradually decreasing the amplification factor of inaudible sound. Specifically, reproducer 103 generates waveform data of inaudible sound from the waveform data of content A (waveform data of the sound source) obtained by obtainer 101 in Step S103, adds the generated waveform data of inaudible sound to the waveform data of content A, and provides the resultant waveform data to loudspeaker 15, thereby reproducing content A together with the inaudible sound. While reproducing content A together with the inaudible sound, reproducer 103 gradually decreases the amplification factor of the inaudible sound being reproduced according to the transition determined in Step S104. After reproducing content A to the end, reproducer 103 proceeds to Step S106.

In Step S106, reproducer 103 reproduces content B while gradually increasing the amplification factor of inaudible sound. Specifically, reproducer 103 generates waveform data of inaudible sound from the waveform data of content B (waveform data of the sound source) obtained by obtainer 101 in Step S103, adds the generated waveform data of inaudible sound to the waveform data of content B, and provides the resultant waveform data to loudspeaker 15, thereby reproducing content B together with the inaudible sound. While reproducing content B together with the inaudible sound, reproducer 103 gradually increases the amplification factor of the inaudible sound being reproduced according to the transition determined in Step S104. After reproducer 103 reproduces content B to the end, the series of processes illustrated in FIG. 8 ends.

Through the series of processes illustrated in FIG. 8, reproduction system 1 can appropriately induce the user's emotion by using two items of content and reproduction of inaudible sound corresponding to the two items of content.

### [4. Transition of amplification factor of inaudible sound (when three items of content are used)]

A plurality of examples of the transition of the amplification factor of inaudible sound (first inaudible sound, second inaudible sound, and third inaudible sound) when reproduction system 1 induces the user's emotion by reproducing three items of content will be described below. Reproducer 103 (more specifically, determiner 112) determines the transition of the amplification factor and determines the amplification factor of inaudible sound for each time.

Reproducer 103 gradually increases and then gradually decreases the amplification factor of the third inaudible sound being reproduced, during reproduction of one or more items of content B. Reproducer 103 may set the amplification factor of the third inaudible sound being reproduced to 0 at the start and end of the reproduction of one or more items of content B.

FIG. 9 is an explanatory diagram illustrating a fourth example of the transition of the amplification factor in this embodiment.

In the transition of the amplification factor illustrated in FIG. 9, reproducer 103 linearly decreases the amplification factor from 100% to 0% with respect to time during the period from time T1 to time T2.

Reproducer 103 linearly increases the amplification factor from 0% to 100% with respect to time during the period from time T2 to time T2A, and then linearly decreases the amplification factor from 100% to 0% with respect to time during the period from time T2A to time T3. Time T2A is any time between time T2 and time T3. For example, time T2A may be at the midpoint between time T2 and time T3.

Reproducer 103 linearly increases the amplification factor from 0% to 100% with respect to time during the period from time T3 to time T4.

Reproducer 103 can generate such transition of the amplification factor that linearly decreases or increases with respect to time by a relatively simple process.

In this way, reproduction system 1 can induce the user's emotion while adjusting the amplification factor of inaudible sound by a relatively simple process.

FIG. 10 is an explanatory diagram illustrating a fifth example of the transition of the amplification factor in this embodiment.

The transition of the amplification factor illustrated in FIG. 10 is set based on the position of the climax part of content.

In FIG. 10, climax part P1 is the climax part of content A, climax part P2 is the climax part of content B, and climax part P3 is the climax part of content C.

In the transition of the amplification factor illustrated in FIG. 10, the transition of the amplification factor during the period from time T1 to time T2 is the same as in FIG. 6.

Reproducer 103 linearly increases the amplification factor from 0% to 100% with respect to time during the period from time T2 to the start of climax part P2, and maintains the amplification factor at 100% during the period from the start to the end of climax part P2. Reproducer 103 linearly decreases the amplification factor from 100% to 0% with respect to time during the period from the end of climax part P2 to time T3.

Reproducer 103 linearly increases the amplification factor from 0% to 100% with respect to time during the period from time T3 to the start of climax part P3, and maintains the amplification factor at 100% during the period from the start of climax part P3 to time T4.

The section from the start of content A to the end of climax part P1 corresponds to the first section, and the section from the start of climax part P3 to the end of content C corresponds to the second section. The section from the start to the end of climax part P2 is also referred to as a third section. The amplification factor in the third section is also referred to as a third value. The third value may be selected from a relatively high amplification factor range (for example, 70% to 100%).

Reproducer 103 can generate such transition of the amplification factor that linearly decreases or increases with respect to time by a relatively simple process.

If content A has a plurality of climax parts, any of the plurality of climax parts may be set as climax part P1. If content B has a plurality of climax parts, any of the plurality of climax parts may be set as climax part P2. If content C has a plurality of climax parts, any of the plurality of climax parts may be set as climax part P3.

If content A has a plurality of climax parts, the last of the plurality of climax parts may be set as climax part P1. If content B has a plurality of climax parts, the period from the start of the first of the plurality of climax parts to the end of the last of the plurality of climax parts may be set as climax part P2. If content C has a plurality of climax parts, the last of the plurality of climax parts may be set as climax part P3.

In this way, reproduction system 1 can more appropriately induce the user's emotion while enhancing the intensity of the user's emotion when reproducer 103 is reproducing the climax part of each content, by adjusting the amplification factor of inaudible sound by a relatively simple process.

The linear changes in the transition of the amplification factor illustrated in each of FIGS. 9 and 10 may be replaced with exponential changes. Thus, reproduction system 1 can more appropriately induce the user's emotion while enhancing the intensity of the user's emotion when reproducer 103 is reproducing the climax part of each content.

### [5. Processing by reproduction system 1 (when three items of content are used)]

FIG. 11 is a flowchart illustrating a second example of processing by reproduction system 1 in this embodiment.

In Step S201, obtainer 101 obtains a target emotion using input IF 11.

In Step S202, obtainer 101 obtains the user's emotion before induction using sensor 12 and recognizer 102.

In Step S203, obtainer 101 obtains an emotion (also referred to as an intermediate emotion) via which the user's emotion is to be induced from the emotion before induction to the target emotion. The intermediate emotion may be input to input IF 11 by the user, or determined by obtainer 101 based on the emotion before induction and the target emotion.

In Step S204, obtainer 101 transmits the user's emotion before induction, the intermediate emotion, and the target emotion to server 20, and requests content to be reproduced by terminal 10. Selector 201 obtains the user's emotion before induction, the intermediate emotion, and the target emotion transmitted by obtainer 101, selects content corresponding to the obtained user's emotion before induction, intermediate emotion, and target emotion, that is, content to be reproduced by terminal 10, and provides the selected content to obtainer 101. The content to be reproduced by terminal 10 includes content A, content B, and content C. Content A is content associated with the user's emotion before induction, content B is content associated with the intermediate emotion, and content C is content associated with the target emotion. Obtainer 101 obtains the content provided by selector 201.

In Step S205, reproducer 103 determines the transition of the amplification factor of inaudible sound. The determined transition of the amplification factor is, for example, the transition of the amplification factor illustrated in FIG. 9 or 10.

In Step S206, reproducer 103 reproduces content A while gradually decreasing the amplification factor of inaudible sound. The process of reproducing content A while gradually decreasing the amplification factor of inaudible sound is performed in the same manner as in Step S105 (FIG. 8), according to the transition determined in Step S205. After reproducing content A to the end, reproducer 103 proceeds to Step S207.

In Step S207, reproducer 103 reproduces content B while gradually increasing the amplification factor of inaudible sound. Reproducer 103 proceeds to Step S208 at a timing (time T2A in FIG. 9 or a point included in climax part P2 in FIG. 10) before content B is reproduced to the end. The process of reproducing content B continues in Step S208. The process of reproducing content B while gradually increasing the amplification factor of inaudible sound is performed in the same manner as in Step S106 (FIG. 8), according to the transition determined in Step S205.

In Step S208, reproducer 103 reproduces content B while gradually decreasing the amplification factor of inaudible sound. The reproduction of content B continues from Step S207. The process of reproducing content B while gradually decreasing the amplification factor of inaudible sound is performed in the same manner as in Step S105 (FIG. 8), according to the transition determined in Step S205. After reproducing content B to the end, reproducer 103 proceeds to Step S209.

In Step S209, reproducer 103 reproduces content C while gradually increasing the amplification factor of inaudible sound. The process of reproducing content C while gradually increasing the amplification factor of inaudible sound is performed in the same manner as in Step S106 (FIG. 8), according to the transition determined in Step S205. After reproducer 103 reproduces content C to the end, the series of processes illustrated in FIG. 11 ends.

The process in Step S203 may be performed by selector 201 instead of obtainer 101. In other words, selector 201 may obtain the intermediate emotion. The intermediate emotion may be determined by selector 201 based on the emotion before induction and the target emotion. In the case where selector 201 determines the intermediate emotion, the emotion before induction and the target emotion required for determining the intermediate emotion may be obtained by obtainer 101 in Steps S201 and S202 and subsequently transmitted to server 20. If the process in Step S203 is executed by selector 201, selector 201 may transmit the intermediate emotion to obtainer 101 in Step S203. In this case, in Step S204, selector 201 selects content A, content B, and content C using the emotion before induction and the target emotion obtained in Steps S201 and S202 and the intermediate emotion obtained in Step S203.

Through the series of processes illustrated in FIG. 11, reproduction system 1 can appropriately induce the user's emotion by using three items of content and reproduction of inaudible sound corresponding to the three items of content.

### (Variation of embodiment)

In this variation, a reproduction system that appropriately induces a user's emotion by using reproduction of inaudible sound will be described. The reproduction system in this variation controls the degree of intensity of inaudible sound depending on the user's emotion being induced, thereby more appropriately inducing the user's emotion.

Reproduction system 1 in this variation, while inducing a user's emotion by reproducing content in the same way as reproduction system 1 in the foregoing embodiment, senses the user's emotion being induced and controls the amplification factor of inaudible sound depending on the user's emotion.

Reproducer 103 holds a target transition that indicates a predetermined transition of the emotion of the user whose emotion is induced. The target transition is information indicating the type of emotion of the user whose emotion is being induced and the intensity of the emotion. When the user's emotion recognized by recognizer 102 deviates from the target transition, reproducer 103 adjusts the amplification factor of the first inaudible sound being reproduced so as to bring the user's emotion closer to the target transition. When the emotion recognized by recognizer 102 deviates from the target transition, reproducer 103 may set the amplification factor of the first inaudible sound being reproduced to 0. Whether the user's emotion deviates from the target transition can be determined by determining whether the difference between the user's emotion and the emotion in the target transition is greater than or equal to a predetermined level.

FIG. 12 is an explanatory diagram illustrating a target transition in this variation.

FIG. 12 illustrates the target transition with respect to time (corresponding to the time code). The target transition illustrated in FIG. 12 is a target transition in the case where the emotion before induction is excitement, the target emotion is relaxation, and the user's emotion is induced using two items of content. Here, the intensity of emotion is indicated in the range from 0% to 100% as an example, although the present disclosure is not limited to such.

During the period from time T1 to time T2, the type of emotion is excitement, and the emotion intensity gradually decreases from 100% to 0%. During the period from time T2 to time T3, the type of emotion is relaxation, and the emotion intensity gradually increases from 0% to 100%.

FIG. 13 is a flowchart illustrating processing by reproduction system 1 in this variation.

When reproducer 103 is reproducing content (for example, Steps S105 and S106 in FIG. 8), reproduction system 1 simultaneously executes the processing illustrated in FIG. 13. It is assumed here that the transition of the amplification factor illustrated in FIG. 5 is determined as the transition of the amplification factor of inaudible sound (Step S104), as an example.

In Step S301, obtainer 101 obtains the time code of the reproduction time (i.e. time point) of the content being reproduced by reproducer 103. The time code indicates the temporal position at which the content is being reproduced by reproducer 103.

In Step S302, obtainer 101 obtains the emotion at the reproduction time in the target transition. The emotion at the reproduction time includes the type of emotion and the intensity of the emotion.

In Step S303, obtainer 101 obtains the user's current emotion (i.e. the user's emotion at the time when this process is being executed).

In Step S304, obtainer 101 determines whether the difference between the emotion at the reproduction position in the target transition obtained in Step S302 and the user's current emotion obtained in Step S303 is greater than or equal to a predetermined level. As one example, obtainer 101 may determine that the difference is greater than or equal to the predetermined level when the type of emotion at the reproduction position in the target transition and the type of the user's current emotion are the same and the intensity of the user's current emotion is at least 10 points higher or lower than the intensity of the emotion at the reproduction position in the target transition. As another example, obtainer 10 may determine that the difference is greater than or equal to the predetermined level when the type of emotion at the reproduction position in the target transition and the type of the user's current emotion are different. When obtainer 101 determines that the difference is greater than or equal to the predetermined level (Step S304: Yes), obtainer 101 proceeds to Step S305. Otherwise, obtainer 101 executes Step S301 again.

In Step S305, obtainer 101 adjusts the amplification factor. For example, when the type of emotion at the reproduction position in the target transition and the type of the user's current emotion are the same and the intensity of the user's current emotion is at least 10 points higher than the intensity of the emotion at the reproduction position in the target transition, obtainer 101 adjusts the current amplification factor in the transition of the amplification factor determined in Step S104 to a lower value. Here, if the amplification factor from the current time onward in the transition of the amplification factor determined in Step S104 is decreasing, obtainer 101 may adjust the amplification factor from the current time onward to be less than or equal to the adjusted current amplification factor.

For example, when the type of emotion at the reproduction position in the target transition and the type of the user's current emotion are the same and the intensity of the user's current emotion is at least 10 points lower than the intensity of the emotion at the reproduction position in the target transition, obtainer 101 adjusts the current amplification factor in the transition of the amplification factor determined in Step S104 to a higher value. Here, if the amplification factor from the current time onward in the transition of the amplification factor determined in Step S104 is increasing, obtainer 101 may adjust the amplification factor from the current time onward to be greater than or equal to the adjusted current amplification factor.

FIG. 14 is an explanatory diagram illustrating an example of an emotion transition in this variation. FIG. 15 is an explanatory diagram illustrating an example of the transition of the amplification factor in this variation.

FIG. 14 illustrates the actual emotion transition of the user whose emotion is induced by reproduction system 1, together with the target transition. The actual emotion transition of the user is expressed as the temporal transition of the user's emotion obtained by sensor 12 and recognizer 102.

The user's actual emotion illustrated in FIG. 14 is the emotion of excitement with an intensity of 100% at time T1 and decreases from 100% after time T1.

Suppose obtainer 101 determines that the intensity of the user's current emotion is at least 10 points higher than the intensity of the emotion at the reproduction position in the target transition (i.e. difference d between the intensity of the emotion at the reproduction position in the target transition and the intensity of the user's current emotion is 10 points or more) at time T5.

In this case, reproducer 103 adjusts the amplification factor at time T5 from value A1 to value A2 that is lower than value A1. Reproducer 103 also adjusts the transition of the amplification factor after time T5 so as to gradually decrease from value A2 after adjustment (see FIG. 15). Thus, reproduction system 1 enhances the effect of decreasing the intensity of the user's excitement, and contributes to inducing the user's emotion with a transition close to the target transition.

Reproducer 103 may set the amplification factor from time T5 onward to 0. For example, reproducer 103 sets the amplification factor from time T5 onward to 0 when obtainer 101 determines in Step S304 that the type of emotion at the reproduction position in the target transition and the type of the user's current emotion are different. Thus, reproduction system 1 can stop reproducing inaudible sound (i.e. stop inducing the user's emotion). When the user is in a state that is not suitable for induction of the user's emotion, inducing the user's emotion may adversely affect the user (for example, cause psychological stress to the user). This can be prevented by the foregoing process.

The foregoing embodiment has been described to illustrate the presently disclosed techniques, through the detailed description and the accompanying drawings.

The structural elements in the detailed description and the accompanying drawings may include not only the structural elements essential for the solution of the problem but also the structural elements not essential for the solution of the problem, to illustrate the presently disclosed techniques. The inclusion of such optional structural elements in the detailed description and the accompanying drawings therefore does not mean that these optional structural elements are essential structural elements.

The foregoing embodiment is intended to be illustrative of the presently disclosed techniques, and therefore various changes, replacements, additions, omissions, etc. can be made within the scope of the appended claims and their equivalents.

### [Industrial Applicability]

The present disclosure can be used, for example, for a system that induces a user's emotion.

### [Reference Signs List]

1 reproduction system
10 terminal
11 input IF
12 sensor
13, 21 communication IF
14, 22 processor
15 loudspeaker
20 server
23 storage
101 obtainer
102 recognizer
103 reproducer
111 generator
112 determiner
113 adjuster
114 adder
201 selector
N network
P, Q route

## Claims

1. A reproduction system for content, the reproduction system inducing a user's emotion from a first emotion to a second emotion, and comprising:
an obtainer that obtains first content corresponding to the first emotion and second content corresponding to the second emotion; and
a reproducer that, using a loudspeaker, (a) reproduces the first content together with first inaudible sound that corresponds to the first content and is created by amplifying a basic signal of the first inaudible sound by a first amplification factor, and thereafter (b) reproduces the second content together with second inaudible sound that corresponds to the second content and is created by amplifying a basic signal of the second inaudible sound by a second amplification factor,
wherein the reproducer:
gradually decreases the first amplification factor of the first inaudible sound being reproduced, during reproduction of the first content; and
gradually increases the second amplification factor of the second inaudible sound being reproduced, during reproduction of the second content.

2. The reproduction system according to claim 1,
wherein the reproducer sets the first amplification factor to 0 at end of the reproduction of the first content, and sets the second amplification factor to 0 at start of the reproduction of the second content.

3. The reproduction system according to claim 1 or claim 2,
wherein the reproducer:
during the reproduction of the first content, maintains the first amplification factor of the first inaudible sound being reproduced at a first value in a first section from start of the first content to end of a climax part included in the first content, and gradually decreases the first amplification factor of the first inaudible sound being reproduced from the first value in a section after the first section; and
during the reproduction of the second content, maintains the second amplification factor of the second inaudible sound being reproduced at a second value in a second section from start of a climax part included in the second content to end of the second content, and gradually increases the second amplification factor of the second inaudible sound being reproduced to the second value in a section before the second section.

4. The reproduction system according to claim 1,
wherein the reproducer gradually decreases the first amplification factor during the reproduction of the first content by linearly decreasing the first amplification factor with respect to time, and gradually increases the second amplification factor during the reproduction of the second content by linearly increasing the second amplification factor with respect to time.

5. The reproduction system according to claim 1,
wherein the reproducer gradually decreases the first amplification factor during the reproduction of the first content by exponentially decreasing the first amplification factor with respect to time, and gradually increases the second amplification factor during the reproduction of the second content by exponentially increasing the second amplification factor with respect to time.

6. The reproduction system according to claim 1, further comprising:
a recognizer that recognizes the user's emotion when the reproducer is reproducing the first content or the second content,
wherein when the user's emotion recognized by the recognizer deviates from a predetermined transition, the reproducer adjusts the first amplification factor of the first inaudible sound being reproduced to bring the user's emotion closer to the predetermined transition.

7. The reproduction system according to claim 1, further comprising:
a recognizer that recognizes the user's emotion when the reproducer is reproducing the first content or the second content,
wherein when the user's emotion recognized by the recognizer deviates from a predetermined transition, the reproducer sets the amplification factor of the first inaudible sound being reproduced to 0.

8. The reproduction system according to claim 1,
wherein the reproducer starts the reproduction of the second content when the reproduction of the first content ends.

9. The reproduction system according to claim 1, inducing the user's emotion from the first emotion to the second emotion via one or more third emotions,
wherein the obtainer obtains one or more items of third content each corresponding to a different one of the one or more third emotions, and
the reproducer:
sequentially reproduces the one or more items of third content each together with third inaudible sound that corresponds to the item of third content, after the reproduction of the first content ends;
starts the reproduction of the second content when reproduction of the one or more items of third content ends; and
during reproduction of each of the one or more items of third content, gradually increases and thereafter gradually decreases a third amplification factor of the third inaudible sound being reproduced.

10. The reproduction system according to claim 9,
wherein the reproducer sets the third amplification factor to 0 at start and end of the reproduction of the one or more items of third content.

11. The reproduction system according to claim 9,
wherein during the reproduction of each of the one or more items of third content, the reproducer maintains the third amplification factor of the third inaudible sound being reproduced at a third value in a third section that includes start to end of a climax part of the item of third content, gradually increases the third amplification factor of the third inaudible sound being reproduced to the third value in a section before the third section, and gradually decreases the third amplification factor of the third inaudible sound being reproduced from the third value in a section after the third section.

12. The reproduction system according to claim 1, further comprising:
a selector that selects the first content corresponding to the first emotion and the second content corresponding to the second emotion from among a plurality of items of content,
wherein the obtainer obtains the first content and the second content selected by the selector.

13. A reproduction method executed by one or more computers included in a reproduction system for content, the reproduction system inducing a user's emotion from a first emotion to a second emotion, the reproduction method comprising:
obtaining first content corresponding to the first emotion and second content corresponding to the second emotion;
with use of a loudspeaker, (a) reproducing the first content together with first inaudible sound that corresponds to the first content and is created by amplifying a basic signal of the first inaudible sound by a first amplification factor, and thereafter (b) reproducing the second content together with second inaudible sound that corresponds to the second content and is created by amplifying a basic signal of the second inaudible sound by a second amplification factor;
gradually decreasing the first amplification factor of the first inaudible sound being reproduced, during reproduction of the first content; and
gradually increasing the second amplification factor of the second inaudible sound being reproduced, during reproduction of the second content.

14. A program for causing a computer to execute the reproduction method according to claim 13.
